# EUROPEAN PATENT SPECIFICATION

(11) **EP 2 542 824 B1**
(45) Date of publication and mention of the grant of the patent: **25.12.2019**
(21) Application number: 11709512.5
(22) Date of filing: 02.03.2011
(51) Int. Cl.: F21Y 115/10

(54) **ENHANCED COLOR RENDERING INDEX EMITTER THROUGH PHOSPHOR SEPARATION**
VERBESSERTER FARBDARSTELLUNGSINDEXEMITTER DURCH PHOSPHORABSCHEIDUNG
ÉMETTEUR À INDICE DE RENDU DES COULEURS AMÉLIORÉ OBTENU PAR SÉPARATION DE LUMINOPHORES

(30) Priority: 03.03.2010 US 339515 P; 16.02.2011 US 201113028863; 24.01.2011 US 435759 P; 22.12.2010 US 975820; 19.01.2011 US 434355 P; 19.12.2010 US 424665 P; 19.12.2010 US 424670 P; 24.09.2010 US 889719; 03.03.2010 US 339516 P; 24.09.2010 US 386437 P; 23.01.2011 US 435326 P; 02.08.2010 US 848825
(43) Date of publication of application: 09.01.2013
(73) Proprietor: Cree, Inc., Durham, NC 27703 (US)
(72) Inventor: TONG, Tao, Oxnard CA 93036 (US); LETOQUIN, Ronan, Fremont CA 94555 (US); KELLER, Bernd, Santa Barbara CA 93111 (US); IBBETSON, James, Santa Barbara CA 93111 (US); NEGLEY, Gerald, Durham NC 27713 (US)
(74) Representative: Dehns
(86) International application number: PCT/US2011/000404
(87) International publication number: WO 2011/109097

(56) References cited:
- WO-A1-2009/107052
- US-A1- 2008 080 165
- US-A1- 2008 128 735
- US-A1- 2009 103 296
- US-A1- 2010 025 700

## Description

### BACKGROUND OF THE INVENTION

### Field of the Invention

This invention relates to solid state lamps and bulbs and in particular to efficient and reliable light emitting diode (LED) based lamps and bulbs having enhanced color rendering index (CRI) through separation of different phosphor components.

### Description of the Related Art

Incandescent or filament-based lamps or bulbs are commonly used as light sources for both residential and commercial facilities. However, such lamps are highly inefficient light sources, with as much as 95% of the input energy lost, primarily in the form of heat or infrared energy. Compact Fluorescent Lamps are more effective than incandescent at converting the electricity into light but require the use of toxic materials such as Hg such that when the lamps are disposed of these toxic materials that can pollute the environment, including underground water supplies. One solution for improving the efficiency of lamps or bulbs is to use solid state devices such as light emitting diodes (LED or LEDs), rather than metal filaments, to produce light.

Light emitting diodes generally comprise one or more active layers of semiconductor material sandwiched between oppositely doped layers. When a bias is applied across the doped layers, holes and electrons are injected into the active layer where they recombine to generate light. Light is emitted from the active layer and from all surfaces of the LED.

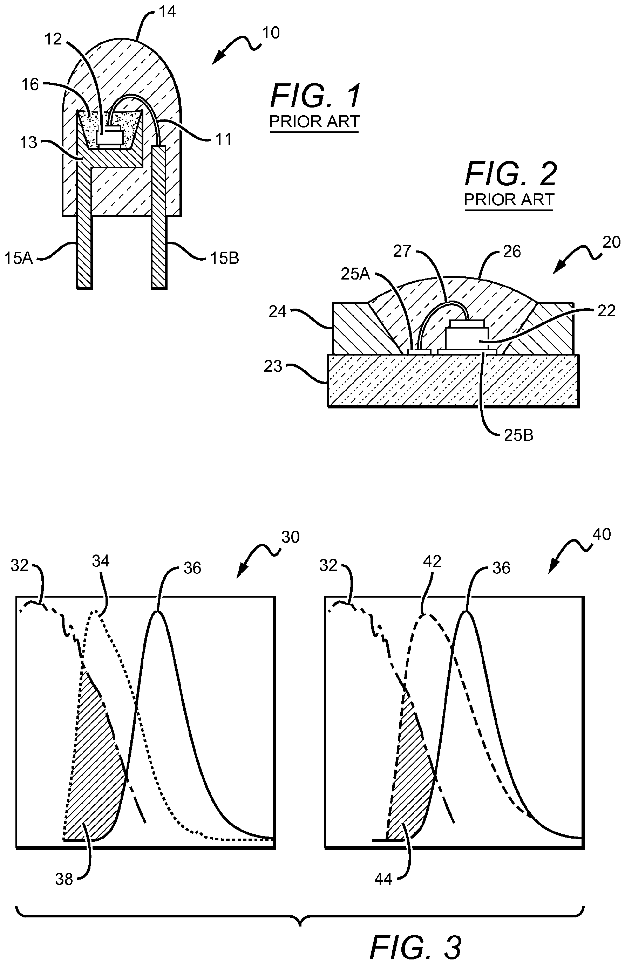

In order to use an LED chip in a circuit or other like arrangement, it is known to enclose an LED chip in a package to provide environmental and/or mechanical protection, color selection, light focusing and the like. An LED package also includes electrical leads, contacts or traces for electrically connecting the LED package to an external circuit. In a typical LED package 10 illustrated in FIG. 1, a single LED or LED chip 12 is mounted on a reflective cup 13 by means of a solder bond or conductive epoxy. One or more wire bonds 11 connect the ohmic contacts of the LED chip 12 to leads 15A and/or 15B, which may be attached to or integral with the reflective cup 13. The reflective cup may be filled with an encapsulant material 16 which may contain a wavelength conversion material such as a phosphor. Light emitted by the LED at a first wavelength may be absorbed by the phosphor, which may responsively emit light at a second wavelength. The entire assembly is then encapsulated in a clear protective resin 14, which may be molded in the shape of a lens to collimate the light emitted from the LED chip 12. While the reflective cup 13 may direct light in an upward direction, optical losses may occur when the light is reflected (i.e. some light may be absorbed by the reflective cup due to the less than 100% reflectivity of practical reflector surfaces). In addition, heat retention may be an issue for a package such as the package 10 shown in FIG. 1a, since it may be difficult to extract heat through the leads 15A, 15B.

A conventional LED package 20 illustrated in FIG. 2 may be more suited for high power operations which may generate more heat. In the LED package 20, one or more LEDs 22 are mounted onto a carrier such as a printed circuit board (PCB) carrier, substrate or submount 23. A metal reflector 24 mounted on the submount 23 surrounds the LED chip(s) 22 and reflects light emitted by the LEDs 22 away from the package 20. The reflector 24 also provides mechanical protection to the LEDs 22. One or more wire bond connections 27 are made between ohmic contacts on the LED chips 22 and electrical traces 25A, 25B on the submount 23. The mounted LEDs 22 are then covered with an encapsulant 26, which may provide environmental and mechanical protection to the chips while also acting as a lens. The encapsulant 26 can also comprise one or more convention materials (e.g. phosphors) that absorb light from the LED chips and re-emit light with different wavelengths of light. The overall emission from the package 20 can be a combination of light from the LEDs 22 and the re-emitted light from the conversion material. The metal reflector 24 is typically attached to the carrier by means of a solder or epoxy bond.

LEDs, such as those found in the LED package 20 of FIG. 2 can also be coated by conversion material comprising one or more phosphors, with the phosphors absorbing at least some of the LED light. The LED can emit a different wavelength of light such that it emits a combination of light from the LED and the phosphor. The LEDs can be coated with a phosphor using many different methods, with one suitable method being described in U.S. Patent Applications Serial Nos. 11/656,759 and 11/899,790, both to Chitnis et al. and both entitled "Wafer Level Phosphor Coating Method and Devices Fabricated Utilizing Method". Alternatively, the LEDs can be coated using other methods such as electrophoretic deposition (EPD), with a suitable EPD method described in U.S. Patent Application No. 11/473,089 to Tarsa et al. entitled "Close Loop Electrophoretic Deposition of Semiconductor Devices".

Lamps have also been developed utilizing solid state light sources, such as LEDs, with a conversion material that is separated from or remote to the LEDs. Such arrangements are disclosed in U.S. Patent No. 6,350,041 to Tarsa et al., entitled "High Output Radial Dispersing Lamp Using a Solid State Light Source." The lamps described in this patent can comprise a solid state light source that transmits light through a separator to a disperser having a phosphor. The disperser can disperse the light in a desired pattern and/or changes its color by converting at least some of the light through a phosphor. In some embodiments the separator spaces the light source a sufficient distance from the disperser such that heat from the light source will not transfer to the disperser when the light source is carrying elevated currents necessary for room illumination. Additional remote phosphor techniques are described in United States Patent No. 7,614,759 to Negley et al., entitled "Lighting Device." US 2010/0025700 A1 discloses a solid state lamp having a yellow phosphor, a red phosphor and an encapsulant therebetween.

The coated LEDs, LED packages and solid state lamps described above can utilize more than one type of conversion material, such as phosphors, to produce the desired overall emission temperature and CRI. Each of the phosphors can absorb light from the LED and re-emit light at a different wavelength of light. Some of these conventional arrangements can utilize a green/yellow phosphor, in combination with a red phosphor, with these phosphors typically absorbing blue LED light and emitting green/yellow and red light, respectively. The re-emitted light can combine with blue LED light to produce the desired emission characteristics.

These conventional arrangements typically mix the different phosphors together at one location, such as in the LED coating, LED package encapsulant, or lamp remote phosphor. One disadvantage of mixing the phosphors together is that there can be significant "cross-talk" or "overlap" between the emission and excitation spectrum for the different phosphors, which can negatively impact the CRI and emission efficiency for the combined emitted light. FIG. 3 shows graphs 30 showing one example of the emission and excitation characteristics for conventional phosphors that can be mixed together. The first graph 30 shows the red phosphor excitation spectrum 32, green phosphor emission spectrum 34, and the red emission spectrum 36. The second graph 40 shows the same red phosphor emission excitation spectrum 32, yellow phosphor emission spectrum 42, and the same red phosphor emission spectrum 36. The shaded overlap regions 38, 44 show the portion of the green and yellow emission spectrums 34, 42 that overlap the red excitation spectrum 32. This overlap can result in "re-absorption" of the converted yellow/green phosphor light by the red phosphor. This converts a portion of the yellow/green that would otherwise contribute to overall emission, to red. In lighting components using these phosphors to produce a white light combination from the LED and phosphors, the re-absorption distorts the resulting white light on the black body curve of a CIE graph such that the yellow/green peak emission can shift to red, and the red peak can shift to blue. This can result in a CRI reduction in the overall emission. There is also some efficiency loss associated with the phosphor absorption and emission process, and repeating this process through re-absorption of the yellow/green light by the red phosphor results in additional efficiency losses. WO2009/107.052 discloses a solid state lamp.

### SUMMARY OF THE INVENTION

The present invention is directed to LED packages, and LED lamps and bulbs, that are arranged to minimize the CRI and efficiency losses resulting from the overlap of conversion material emission and excitation spectrum. In different devices having conversion materials with this overlap, the present invention arranges the conversion materials to reduce the likelihood that re-emitted light from a first conversion material will encounter the second conversion material to minimize the risk of re-absorption. In some embodiments this risk is minimized by different arrangements where there is separation between the two phosphors. When viewed from a first aspect the invention provides a solid state lamp as claimed in claim 1.

One embodiment of a solid state lamp according to the present disclosure comprises an LED and a first conversion material. The lamp further comprises a second conversion material spaced from the first conversion material with light from the LED passing through the second conversion material. The second conversion material wavelength converts and re-emitting at least some of the LED light, with less than 50% of said re-emitted light from the second phosphor passing into said first conversion material.

An embodiment of a solid state lamp according to the present disclosure comprises a plurality of LEDs and a red phosphor on at least one of the LEDs. The red phosphor is arranged so that light from its at least one of the LEDs passing through the red phosphor. The lamp also comprises a yellow or green phosphor separated from and over the LEDs, with light from the LEDs also passing through the yellow or green phosphor.

Another embodiment of a solid state lamp according to the present disclosure comprises an LED having a first phosphor coating where the first phosphor absorbs some of the light emitted from the LED and re-emitting a different wavelength of light. The lamp also comprises a second phosphor spaced from the first phosphor with light from the LED passing through the second phosphor. At least some of the LED light is absorbed by the second phosphor and re-emitted at a respective different wavelength of light. The emission spectrum of the light re-emitted from the second phosphor overlaps the excitation spectrum of the first phosphor, and wherein the majority of light from the second phosphor does not encounter the first phosphor.

These and other embodiments and advantages of the invention will become apparent from the following detailed description and the accompanying drawings which illustrate by way of example the features of the invention.

### BRIEF DESCRIPTION OF THE DRAWINGS

FIG. 1 shows a sectional view of one embodiment of a prior art LED lamp;
FIG. 2 shows a sectional view of another embodiment of a prior art LED lamp;
FIG. 3 is a graph showing overlap between the excitation spectrum and emission spectrum of two phosphors;
FIG. 4 is a sectional view of one embodiment of a lamp according to the present disclosure
FIG. 5 is a sectional view of another embodiment of a lamp according to the present disclosure
FIG. 6 s a graph showing the emission spectrum for different lamps according to the present invention;
FIG. 7 is a sectional view of another embodiment of a lamp according to the present disclosure
FIG. 8 is a sectional view of another embodiment of a lamp according to the present disclosure
FIG. 9 is a sectional view of another embodiment of a lamp according to the present disclosure
FIG. 10 is a sectional view of another embodiment of a lamp according to the present disclosure
FIG. 11 is a sectional view of another embodiment of a lamp according to the present disclosure
FIG. 12 is a sectional view of another embodiment of a lamp according to the present disclosure
FIG. 13 is a sectional view of one embodiment of a lamp according to the present disclosure comprising an optical cavity;
FIG. 14 is a sectional view of another embodiment of a lamp according to the present disclosure also comprising an optical cavity;
FIG. 15 is a CIE diagram showing different lighting combinations;
FIG. 16 is a sectional view of another embodiment of a lamp according to the present disclosure also comprising an optical cavity;
FIG. 17 is a sectional view of another embodiment of a lamp according to the present invention also comprising an optical cavity;
FIG. 18 is a sectional view of another embodiment of a lamp according to the present invention also comprising an optical cavity; and
FIG. 19 is an elevation view of another embodiment of a lamp according to the present disclosure
FIG. 20 is an exploded view of the lamp shown in FIG. 19;
FIG. 21 is an exploded view of another embodiment of a lamp according to the present disclosure
FIG. 22 is an elevation view of still another embodiment of a lamp according to the present disclosure
FIG. 23 is a perspective view of another embodiment of a lamp according to the present disclosure and
FIG. 24 is a sectional view of one embodiment of a lamp or display according to the present disclosure

### DETAILED DESCRIPTION OF THE INVENTION

The present invention is directed to different embodiments of solid state lamps, bulbs and LED packages utilizing multiple conversion materials to produce the desired overall emission characteristics, with the conversion materials separated to reduce the impact of emission and excitation spectrum overlap. Some embodiments of the present invention are directed to solid state lamps arranged to produce white light with a warm color temperature by utilizing two separate phosphor components in a way that eliminates or reduces the re-absorption (interaction) between the two component phosphors. This can result in emission of warm white light with a CRI that is significantly higher than those arrangements where re-absorption is not addressed, such as where the different phosphors are mixed.

The re-absorption is minimized by providing physical separation between the two phosphors to minimize interaction or crosstalk between the two. That is, the separation reduces the amount of light from the first phosphor that interacts with the second phosphor, to reduce or eliminate the re-absorption by the second phosphor. This in turn reduces the color shift in CRI that may be experienced by this re-absorption.

In some embodiments, the first phosphor can re-emit a wavelength of light that does not overlap with the excitation spectrum of the second phosphor such that light re-emitted from the first phosphor passes through the second phosphor without risk of being absorbed by the second phosphor. The emission spectrum of the second phosphor, however, may emit light that at least partially overlaps with the excitation spectrum of the first phosphor. In arrangements where light from the second phosphor passes through the first phosphor, there may be a risk of light from the second phosphor being re-absorbed by the first phosphor. The separation of the phosphors minimizes the amount of re-emitted light that encounters the first phosphor, thereby minimizing the amount of light that can be re-absorbed by the first phosphor. To allow light from the first phosphor to pass through the second phosphor, in some embodiments can comprise materials such that the emission spectrum of the first phosphor does not overlap the excitation spectrum of the second phosphor.

In some embodiments, the second phosphor can comprise a yellow/green phosphor that absorbs blue light and re-emits yellow/green light, and the first phosphor can comprise a red phosphor that absorbs blue light and emits red light, with the emission spectrum of the yellow/green phosphor overlapping the excitation spectrum of the red phosphor. These embodiments provide separation between the first and second phosphors in a way that minimizes the chances that the yellow/green phosphor emission would encounter the red phosphor, and as a result, there is little chance of re-emitted yellow/green light being reabsorbed by the red phosphor. Compared to the mixed phosphor arrangement, the phosphor separation results in overall lamp or package emission having a higher CRI and higher phosphor efficiency.

The separation can take many different forms that can provide different reductions in crosstalk between the first and second phosphors. In some embodiments the separation can comprise separate layers on an LED chip, with each layer being a different one of the phosphors. The separate layers can be one on top of the other, or can comprise side by side layers on the LED. While this arrangement reduces the amount of crosstalk between the phosphors compared to the mixed embodiment, a certain level of crosstalk remains because of the proximity of the two phosphors.

In other embodiments, one of the phosphors can be provided remote to the other phosphor, and this can take many different forms. In some embodiments, one of the phosphors can comprise a conformal coat over one or more LEDs and the second phosphor can be remote to the first phosphor, such as in the shape of dome over the LEDs. This arrangement reduces even further the chances of crosstalk between the first and second phosphors by further reducing the chances that light emitted from the second phosphor would encounter the first phosphor.

In still other embodiments, the likelihood of crosstalk can be reduced further by arranging the first phosphor over an LED, such as in an LED package, and arranging the second phosphor over an LED in its own package. The packages can be arranged in relation to one another such that the light remitted from the first phosphor in the first package does not emit onto the second package, such that there is no opportunity for crosstalk between the two. In some embodiments, the emitters can be arranged adjacent to one another so that their emission combines as overall lamp light, but in a way such that they do not illuminate one another. There are many other arrangements that can provide these different levels of separation between the phosphors.

There are other advantages that can be provided by the present invention including but not limited to cost saving. For separation where one of the phosphors is conformal coated on the LED, less phosphor is typically used in the conformal coat. As a result, the more expensive of the phosphors can be used for the conformal coat. For example, established yellow phosphors like YAG:Ce³⁺ have very low cost, but by contrast red phosphors, such as typical Eu doped red phosphors, can be much more expensive. By applying the red phosphor as a conformal coating, it reduces the amount of the more expensive phosphor needed for each system, with the resulting cost savings.

Another advantage of this arrangement is that having at least one of the phosphors remote can lead to higher phosphor efficiency compared to lamps with all the phosphors on the LED chips. One way that the efficiency is enhanced is through the optical cavity effect created in the space between the emitters and the remote phosphor. With remote phosphor configurations there can also be more flexibility in designing a highly reflective cavity than in embodiment having phosphor coatings on the chip. There can also be a thermal benefit in having a remote phosphor. The remote phosphor can be thermally isolated from the chip heating resulting in less thermal quenching of the phosphor material. The third benefit is less optical quenching of the phosphor material. For some phosphors, their quantum efficiency drops with higher light flux density passing through the phosphor materials. By having a remote phosphor, the flux density passing through the phosphor can be reduced, thereby reducing optical quenching. The reduction in thermal and optical quenching can lead to more stable light output over time, even at high operating temperatures.

The present invention is described herein with reference to certain embodiments, but it is understood that the invention can be embodied in many different forms and should not be construed as limited to the embodiments set forth herein. In particular, the present invention is described below in regards to certain LED packages or lamps having one or multiple LEDs or LED chips or LED packages in different configurations, but it is understood that the present invention can be used for many other lamps having many different configurations. Examples of different lamps arranged in different ways according to the present invention are described below and in U.S. Provisional Patent application Serial No. 61/435,759, to Le et al., entitled "Solid State Lamp", filed on January 24, 2011.

Different embodiments of the lamps can have many different shapes and sizes, with some embodiments having dimensions to fit into standard size envelopes, such as the A19 size envelope. This makes the lamps particularly useful as replacements for conventional incandescent and fluorescent lamps or bulbs, with lamps according to the present invention experiencing the reduced energy consumption and long life provided from their solid state light sources. The lamps according to the present invention can also fit other types of standard size profiles including but not limited to A21 and A23.

The embodiments below are described with reference to LED of LEDs, but it is understood that this is meant to encompass LED chips and LED packages. The components can have different shapes and sizes beyond those shown and different numbers of LEDs can be included.

The present invention is described herein with reference to conversion materials, phosphors, phosphor layers and related terms. The use of these terms should not be construed as limiting. It is understood that the use of the term phosphor or phosphor layers is meant to encompass and be equally applicable to all wavelength conversion materials.

It is also understood that the lamp's light source may be comprised of one or multiple LEDs, LED chips or LED packages, and in embodiments with more than one, the LEDs, LED chips or LED packages may have different emission wavelengths. Although the present invention is described below with reference to phosphor conversion materials, it is understood that many other conversion materials can be used. The present invention is described herein with reference to conversion materials, phosphor layers being remote to one another. Remote in this context refers being spaced apart from and/or to not being on or in direct thermal contact. The present invention is also described with reference to LED chips, but it is understood that this can encompass LEDs and LED packages.

It is also understood that when an element such as a layer, region or substrate is referred to as being "on" another element, it can be directly on the other element or intervening elements may also be present. Furthermore, relative terms such as "inner", "outer", "upper", "above", "lower", "beneath", and "below", and similar terms, may be used herein to describe a relationship of one layer or another region. It is understood that these terms are intended to encompass different orientations of the device in addition to the orientation depicted in the figures.

The phosphors are described herein with referenced to red emitting phosphors, but it is understood that this can include other colors close to red in the light spectrum, such as orange. The phosphors are also described as being yellow emitting, but this can also comprise green emitting phosphors.

Although the terms first, second, etc. may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the teachings of the present invention.

Embodiments of the invention are described herein with reference to cross-sectional view illustrations that are schematic illustrations of embodiments of the invention. As such, the actual thickness of the layers can be different, and variations from the shapes of the illustrations as a result, for example, of manufacturing techniques and/or tolerances are expected. Embodiments of the invention should not be construed as limited to the particular shapes of the regions illustrated herein but are to include deviations in shapes that result, for example, from manufacturing. A region illustrated or described as square or rectangular will typically have rounded or curved features due to normal manufacturing tolerances. Thus, the regions illustrated in the figures are schematic in nature and their shapes are not intended to illustrate the precise shape of a region of a device and are not intended to limit the scope of the invention.

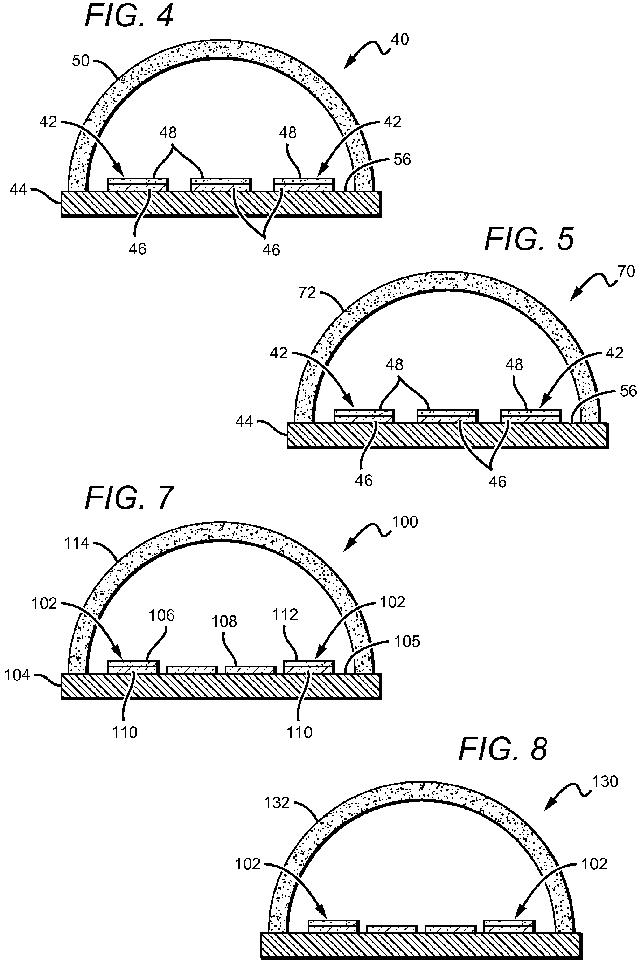

FIG. 4 shows one embodiment of a lamp 40 according to the present disclosure comprising a plurality of LED chips 42 mounted onto a carrier 44 that can comprise a printed circuit board (PCB) carrier, substrate or submount. The carrier 44 can comprise interconnecting electrical traces (not shown) for applying an electrical signal to the LED chips 42. Each of the LEDs chips 42 can comprise an LED 46 with a conformal coat of first phosphor material 48 on the LED 46. Many different commercially available LEDs can be utilized emitting many different colors of light, and many different phosphor materials can be used such as one of those listed below. In some embodiments, the LED can comprise a conventional blue emitting LED, and the conversion material can comprise a red phosphor that absorbs at least some of the blue light from the LED and re-emits red light. In the embodiment shown, the red phosphor is arranged to convert only a portion of the blue light from the LED chip such that the LED chips emit both blue and red light. By allowing a portion of the blue light to pass through the red phosphor, the LED chips 42 do not need to operate with the red phosphor in saturation. This can allow for the LED chips 42 to operate with higher emission efficiency. In other embodiments, the red phosphor can be arranged to operate in saturation by converting essentially all of the blue light to red, such that the LED chips emit substantially red light.

A second phosphor 50 is included over and spaced apart from the LED chips 42, so that at least some of the light from the LED chips 42 passes through the second phosphor 50. The second phosphor 50 should be of the type that absorbs the wavelength of light from the LED chips 42 and re-emits a different wavelength of light. In the embodiments shown, the second phosphor is in a dome shape over the LED chips, but it is understood that the second phosphor can take many different shapes and sizes such as disks or globes. The second phosphor can be in the form of a phosphor carrier characterized as comprising a conversion material in a binder, but can also comprise a carrier that is thermally conductive and a light transmitting material. Phosphors arranged with thermally conductive materials are described in U.S. Provisional Patent Application No. 61/339,516, filed on March 3, 2010 and titled "LED Lamp Incorporating Remote Phosphor With Heat Dissipation Features". With the second phosphor formed in a dome, an open space is formed between the LED chips 42 and the second phosphor 50.

In other embodiments, an encapsulant can be formed or mounted over the LED chips 42 and the second phosphor 50 can be formed or deposited as a layer on the top surface of the encapsulant. The encapsulant can take many different shapes, and in the embodiment shown is dome-shaped. In still other embodiments having an encapsulant, the second phosphor 50 can be formed within the encapsulant as a layer, or in regions of the encapsulant.

Many different phosphors can be used in different embodiments according to the present invention with the second phosphor in the embodiment shown comprising a phosphor that absorbs blue light from the LED chips and emits yellow light. Many different phosphors can be used for the yellow conversion material including commercially available YAG:Ce phosphors. As discussed above, a portion of the blue light from the LED chips passes through the first (red) phosphor without being converted. The blue and red light from the LED chips 42 pass through the second phosphor where a portion of the blue light is converted to yellow. A portion of the blue light can also pass through the second phosphor with the red light from the LED chips 42. As a result, the lamp emits light that is a combination of blue, red and yellow light, with some embodiments emitting a warm white light combination with the desired color temperature.

The blue light from the LED chips 42 can also be converted by many other phosphors that provide a full range of broad yellow spectral emission. Beyond the YAG:Ce mentioned above, these conversion materials can be made of phosphors based on the (Gd,Y)₃(Al,Ga)₅O₁₂:Ce system. Other yellow phosphors that can be used for creating white light when used with a blue emitting LED based emitters include but not limited to:
Tb₃₋ₓREₓO₁₂:Ce (TAG) ;
RE=Y, Gd, La, Lu; and
Sr_{2-x-y}BaₓCa_{y}SiO₄:Eu_{.}

The second phosphor 50 can also be arranged with more than one yellow or green emitting phosphor either mixed together or the second phosphor can comprise more than one layer of yellow or green emitting phosphor.

The first phosphor 48 on the LED chips 42 can comprise many different commercially available phosphors, such as Eu doped red phosphors that can absorb blue light from the LED chip and red light. Other red emitting phosphors that can be used including:
SrₓCa₁₋ₓS:Eu, Y; Y=halide;
CaSiAlN₃:Eu; or
Sr_{2-y}Ca_{y}SiO₄: Eu

Different sized phosphor particles can be used including but not limited to particles in the range of 10 nanometers (nm) to 30 micrometers (µm), or larger. Smaller particle sizes typically scatter and mix colors better than larger sized particles to provide a more uniform light. Larger particles are typically more efficient at converting light compared to smaller particles, but emit a less uniform light. In some embodiments, the first and/or second phosphor can be provided in a binder, and the phosphor can also have different concentrations or loading of phosphor materials in the binder. A typical concentration is in a range of 30-70% particle concentration by weight. In one embodiment, the phosphor concentration for the first and second phosphors is approximately 65% by weight, and is preferably uniformly dispersed. The first and second phosphors can also be formed in layers having different regions with different conversion materials and different concentrations of conversion material.

When the phosphors are provided in a binder, different materials can be used, with materials preferably being robust after curing and substantially transparent in the visible wavelength spectrum. Suitable materials include silicones, epoxies, glass, inorganic glass, dielectrics, BCB, polymides, polymers and hybrids thereof, with the preferred material being silicone because of its high transparency and reliability in high power LEDs. Suitable phenyl- and methyl-based silicones are commercially available from Dow® Chemical. The binder can be cured using many different curing methods depending on different factors such as the type of binder used. Different curing methods include but are not limited to heat, ultraviolet (UV), infrared (IR) or air curing.

The first and second phosphors 48, 50 can be applied using different processes including but not limited to spin coating, sputtering, printing, powder coating, electrophoretic deposition (EPD), and electrostatic deposition, among others. Various deposition methods and systems are described in U.S. Patent Application Publication No. 2010/0155763, to Donofrio et al., titled "Systems and Methods for Application of Optical Materials to Optical Elements," and also assigned to Cree, Inc. As mentioned above, the phosphor layer 48 can be applied along with a binder material, but it is understood that a binder is not required. In still other embodiments, the second phosphor can be fabricated separately in a dome and then mounted to the carrier 44 and over the LED chips 42.

The lamp can also be used in conjunction with a diffuser as described in U.S. Provisional Patent Application No. 61/339,515, titled "LED Lamp With Remote Phosphor and Diffuser configuration". This application also describes many different shapes and sizes for the second phosphor or phosphor carrier that can also be used in the in embodiments of the invention described herein.

Alternatively, scattering materials can be used in conjunction with the phosphors, with one such scattering material comprising scattering particles. The scattering particles can also be included in a binder material that can be the same as those described above in reference to the binder used with the first and second phosphors. The scattering particles can be provided in different concentrations depending on the application and materials used. A suitable range for scattering particle concentration is from 0.01% to 0.2%, but it is understood that the concentration can be higher or lower. In some embodiments the concentration can be as low as 0.001%. It is also understood that the scattering particles can be in different concentrations in different regions. For some scattering particles there can be an increase in loss due to absorption for higher concentrations. Thus, the concentrations of the scattering particles can be chosen in order to maintain an acceptable loss figure, while at the same time dispersing the light to provide the desired emission pattern.

The scattering particles can comprise many different materials including but not limited to:
silica;
kaolin;
zinc oxide (ZnO);
yttrium oxide (Y₂O₃);
titanium dioxide (TiO₂);
barium sulfate (BaSO₄);
alumina (Al₂O₃);
fused silica (SiO₂);
fumed silica (SiO₂);
aluminum nitride;
glass beads;
zirconium dioxide (ZrO₂);
silicon carbide (SiC);
tantalum oxide (TaO₅);
silicon nitride (Si₃N₄);
niobium oxide (Nb₂O₅);
boron nitride (BN); or
phosphor particles (e.g., YAG:Ce, BOSE)
More than one scattering material in various combinations of materials or combinations of different forms of the same material may be used to achieve a particular scattering effect. The scattering particles can be in many different locations in the lamp.

The lamp 40 can also comprise a reflective material/layer 56 on the surfaces of the carrier 44 not covered by the LED chips 42. The reflective layer 56 allows for lamp 40 to efficiently recycle photons, and increase the emission efficiency of the lamp. Light that emits back toward the carrier is reflected by the reflective material/layer 56 such that absorption is reduced and the light can contribute to useful emission from the lamp. It is understood that the reflective layer 56 can comprise many different materials and structures including but not limited to reflective metals or multiple layer reflective structures such as distributed Bragg reflectors. It is also understood that the surfaces of the LEDs, as well as the first and second phosphors can be shaped or textures to enhance light extraction.

During operation, an electrical signal is applied to the lamp 40 causing the LEDs within the LED chips 42 to emit blue light that passes through the first phosphor 48. A portion of the blue LED light is absorbed by the red phosphor 48 and is re-emitted as red light. A potion of the blue light also passes through the red first phosphor 48 without being converted, such that the LED chips 42 emit both red and blue light. Light from the LED chips 42 is emitted through the second phosphor 50 where at least a portion of the blue light from the LED light is converted to yellow light, and in some embodiments a portion of the light from the LED chips 42 passes through the second phosphor 50 without being converted. As mentioned above, this allows the lamp to emit a white light combination of blue, red and yellow light.

When the blue component of the light from the LED chips is absorbed by the second phosphor 50 it is re-emitted in all directions. In the embodiment shown, as the phosphor particles absorb the blue light the yellow light is re-emitted forward and out of the lamp, and back toward the LED chips. The light that is emitted back toward the LED chips 42 can encounter the first phosphor 48 on the LED chips 42. As mentioned above, the excitation spectrum of many red phosphors overlaps the emission spectrum of many yellow/green phosphors, so light from the second phosphor 50 that is emitted back toward the LED chips 42, risks being absorbed by the first phosphor. This absorbed yellow light can be re-emitted as red light, which can result in a color shift for the overall lamp emission. By spacing the second phosphor 50 as shown in lamp 40 (instead of mixing the phosphors), the chances that second phosphor light would encounter the first phosphor is greatly reduced. Most emission paths of yellow light from the second phosphor 50 would not encounter the first phosphor and would not risk re-absorption. Much of the light emitted back toward the LED chips 42 is reflected off the reflective layer on the carrier 44 such that it can contribute to useful emission from the lamp.

In some embodiments, the second phosphor is spaced from the first so that less than 50% of the re-emitted light second phosphor encounters or passes into the first phosphor, while in other embodiments less than 40% encounter or passes into the first phosphor. In still other embodiments, less than 25% of the second phosphor light encounters the first phosphor, while in other embodiments less than 10% encounter the first phosphor.

Different lamps according to the present invention can be arranged in many different ways with many different features and materials. FIG. 5 shows another embodiment of a lamp 70 according to the present disclosure having many similar features and components as lamp 40 shown in FIG. 4 and described above, and operates in much the same way. For similar features and components the same reference numbers are used with the understanding that the description of lamp 40 applies equally to this embodiment or other embodiments below using the same reference numbers.

The lamp 70 includes LED chips 42 each of which is mounted on a carrier 44, with each of the LED chips 42 comprising a blue emitting LED coated by a red first phosphor 48. The uncovered surfaces of the carrier 44 can also comprise a reflective layer 56. The lamp 70 includes a second phosphor 72 over the LED chips that is arranged in much the same way as second phosphor 50 described above. In this embodiment, however, the second phosphor 50 comprises a phosphor material that absorbs blue light and re-emits green light. For example, the following phosphors can be used to generate green light:
SrGa₂S₄:Eu;
Sr_{2-y}Ba_{y}SiO₄:Eu;
SrSi₂O₂N₂:Eu;
Lu₃Al₅O₁₂ doped with Ce³⁺;
(Ca,Sr,Ba)Si₂O₂N₂ doped with Eu²⁺;
CaSc2O4:Ce³⁺; and
(Sr,Ba) 2SiO4:Eu²⁺.

The lamp 70 operates in much the same way as lamp 40, but emits a combination of blue, red and green light. In some embodiments this combination can produce a lamp emission that is a warm white light with the desired temperature.

Beyond those listed above, the following lists some additional suitable phosphors that can be used as the first or second phosphors. Each exhibits excitation in the blue and/or UV emission spectrum, provides a desirable peak emission, has efficient light conversion, and has acceptable Stokes shift:
YELLOW/GREEN
   (Sr,Ca,Ba) (Al,Ga)₂S₄:Eu²⁺
   Ba₂ (Mg, Zn) Si₂O₇:Eu²⁺
   Gd₀.₄₆Sr_{0.31}Al_{1.23}OₓF_{1.38}:Eu²⁺_{0.06}
   (Ba_{1-x-y}SrₓCa_{y})SiO₄:Eu
   Ba₂SiO₄:Eu²⁺
RED
   Lu₂O₃: Eu³⁺
   (Sr₂₋ₓLaₓ) (Ce₁₋ₓEUₓ)O₄
   Sr₂Ce₁₋ₓEuₓO₄
   Sr₂₋ₓEuₓCeO₄
   SrTiO₃:Pr³⁺,Ga³⁺
   CaAlSiN₃:Eu²⁺
   Sr₂Si₅N₈: Eu²⁺

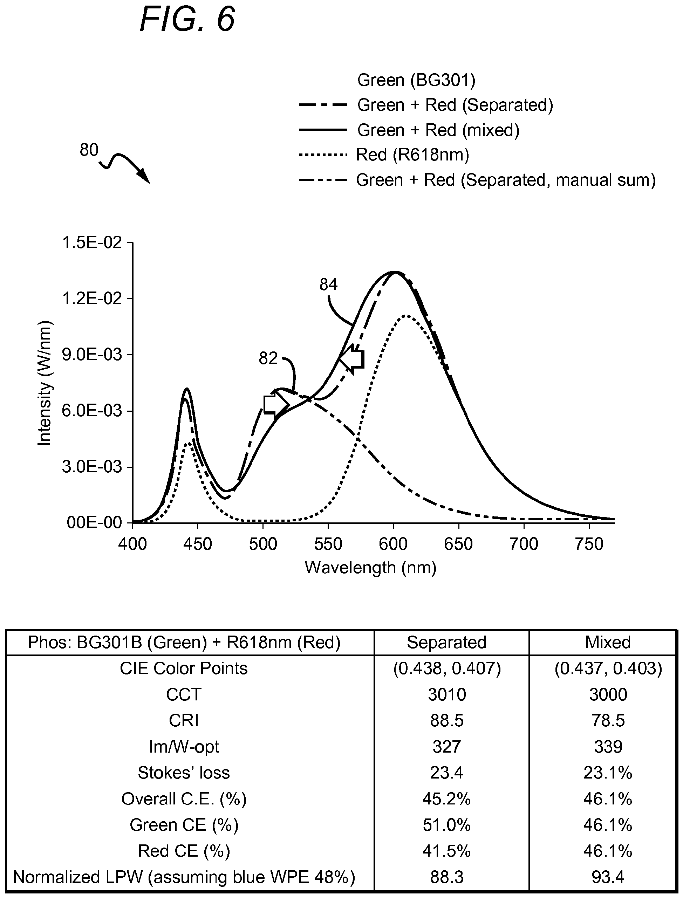

FIG. 6 is a graph 80 showing a comparison of the emission characteristics for a lamp with mixed phosphor compared to a similar lamp with separate phosphors as described above. The first emission spectrum 82 is for a lamp with separated red and green phosphors, with the spectrum showing peaks in the blue, green and red wavelength spectrums. The second emission spectrum 84 is for a similar lamp with mixed red and green phosphors and shows a reduction and shift in the blue peak compared to the separated spectrum 82, as well as a shift in the red peak. The overall phosphor conversion efficiency for both is approximately the same (42.5% for separated vs. 46.1% for mixed), but the CRI for the separated is approximately 88.5 for separated phosphors verses 78.5 for the mixed phosphor configuration.

FIG. 7 shows still another embodiment of a lamp 100 according to the present disclosure comprising a combination of different LED chips emitting different colors of light to generate the desired lamp emission. The lamp 100 comprises LED chips 102 mounted on a carrier 104, with the carrier being similar to carrier 44 described above. The carrier can have a reflective layer 105 covering its surface between the LED chips 102. The LED chips 102 can comprise red emitting LED chips 106 and blue emitting LED chips 108 that together can produce the desired red and blue light components of the lamp emission. The red LED chips 106 can comprise an LED 110 coated by a red phosphor 112 as described above, with some embodiments of the LEDs 110 emitting blue light and the red phosphor 112 absorbing at least some of the blue light and re-emitting red light. In some embodiments the red phosphor 112 can be arranged to absorb substantially all of the blue LED light, while in other embodiments the red phosphor 112 can be arranged to absorb only a portion of the blue light.

Similar to the embodiments above, a second phosphor 114 is included over and spaced apart from the LED chips 102, with the second phosphor comprising a phosphor that absorbs blue light and re-emits yellow light. During operation red and blue light from the LED chips passes through a second phosphor where some of the blue light is converted to yellow. The lamp 100 emits a white light combination of blue, red and yellow. As described above, the separation between the red and yellow phosphors minimizes the risk that the red phosphor will re-absorb the yellow light from the second phosphor.

FIG. 8 shows another lamp 130 according to the present disclosure that is similar to lamp 100. Instead of having a yellow emitting second phosphor, lamp 130 has a green emitting second phosphor 132 that absorbs some of the blue light from its LED chips 102 such that the lamp emits a white light combination of blue, red and green.

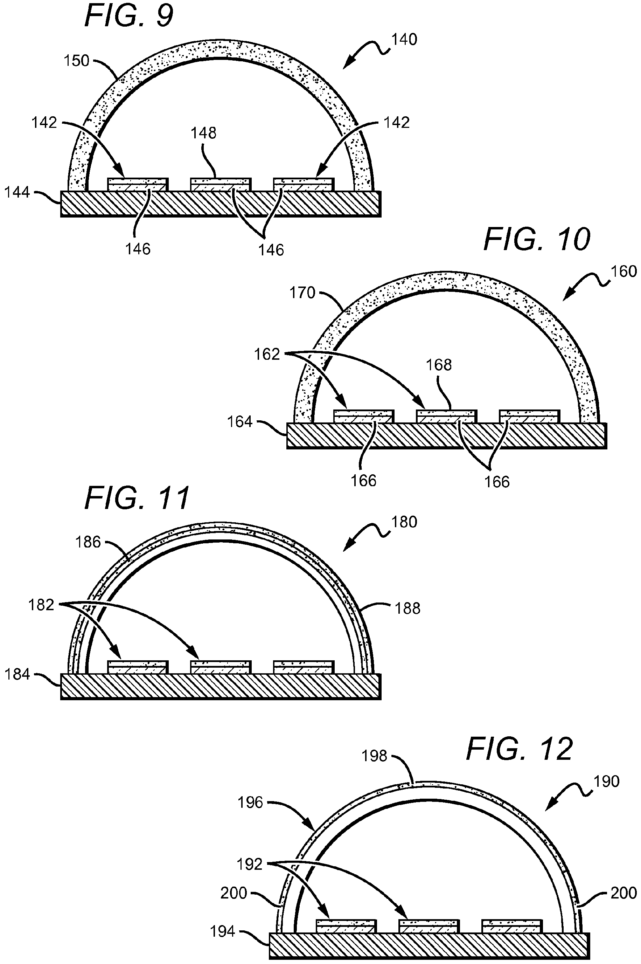

As mentioned above, the lamps according to the present invention can be arranged in many different ways with many different phosphor materials. FIG. 9 shows another embodiment of lamp 140 according to the present disclosure comprising LED chips 142 mounted to a carrier 144 as described above. In this embodiment, however, the LED chips comprise blue emitting LEDs 146 with a conformal coat of a yellow first phosphor 148. The first phosphor 148 absorbs at least some of the light from the LED 146 and re-emit a yellow light. The second phosphor 150 is in the form of dome over the LED chips 142 and comprises a red phosphor. Blue (and yellow) light from the LED chips 142 passes through the second phosphor 150 where at least some of the blue LED light is absorbed by the second phosphor on re-emitted as red light. The lamp 140 emits a white light combination of blue, yellow and red.

FIG. 10 shows still another embodiment of a lamp 160 according to the present disclosure having LED chips 162 mounted on a carrier 164, with each of the LED chips 162 comprising an LED 166 and a conformal coat of a green first phosphor 168. At least some blue light from each of the LEDs 166 passes through the first phosphor 168 and is converted to green light, such that each of the LED chips 162 emits green and blue light. The blue (and green) LED light passes through a second dome shaped second red phosphor 170. At least some of the LED light is converted to red at the second phosphor with the lamp 160 emitting a white light combination of blue, red and green light.

FIG. 11 shows still another embodiment of a lamp 180 according to the present disclosure comprising blue emitting LED chips 182 mounted to a carrier 184. Instead of being conformal coated on the LED chips 182, a first red phosphor 186 is provided in a dome over the LED chips 182, with light from the LED chips 182 passing through the first phosphor 186 where at least some of it is converted to red light. A second green phosphor 188 is included in a dome over the first phosphor 186 with red light from the first phosphor 186 and the blue light from the LED chips 182 passing through the second phosphor 188 where at least some of the light is converted to green light. The lamp emits a white light combination of blue, red and green light. The second phosphor 188 is shown on the first phosphor 186, but it is understood that there can be a space between the first and second phosphors 186,188 and that the phosphors can be provided in different order, such as having the green phosphor on the inside and the red phosphor on the outside.

FIG. 12 shows another embodiment of a lamp 190 according to the present disclosure having blue emitting LED chips 192 on a carrier 194. The lamp includes red and green phosphors, with the phosphor shown being in different regions of a phosphor dome 196. In the embodiment shown, the red first phosphor 198 is on the top portion of the dome, and the green second phosphor 200 is on the lower portions of the dome 196. Blue light from the LED chips passes through the first and second phosphors portions 198, 200 where at least some LED light is converted to red and green light, respectively. The lamp emits a white light combination of blue, red and green light. It is understood that other embodiments can comprise different regions of phosphors arranged in different ways. Each of the lamps shown in FIGs. 9-12 can comprise reflective layers on the carrier as described above.

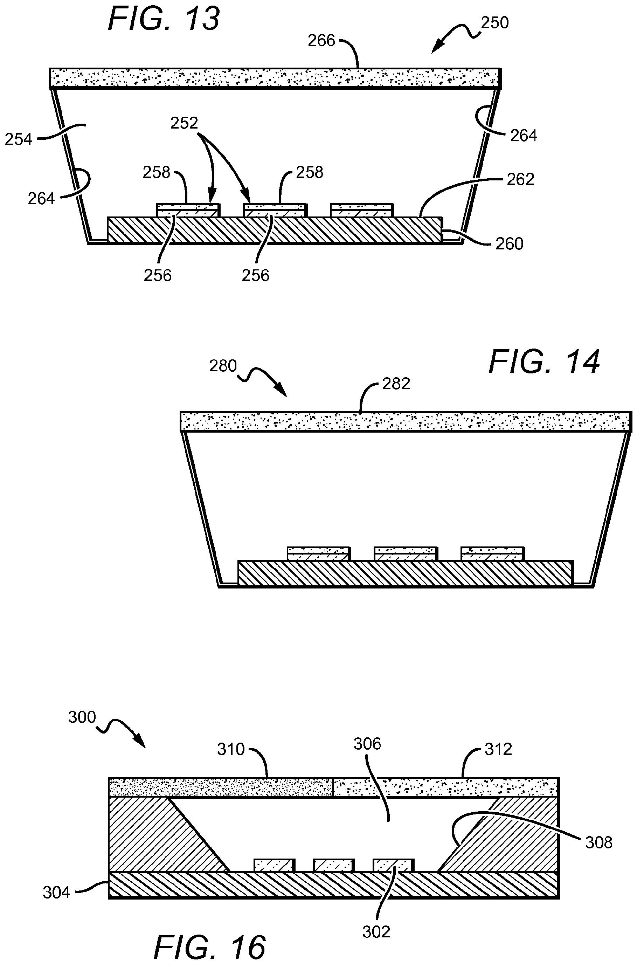

As mentioned above, the lamps and their phosphors can be arranged in many different ways according to the present disclosure. FIG. 13 shows still another embodiment of a lamp 250 having its LED chips 252 mounted within an optical cavity 254. Like the embodiments above, the LED chips 252 can comprise an LED 256 coated by a first phosphor 258, and in some embodiments of the LED 256 emits blue light and the first phosphor is a red phosphor absorbing at least some of the blue LED light and re-emitting red light. In this embodiment, the red phosphor absorbs only a portion of the blue light from the LED, such that the LED chips 252 emit red and blue light.

The LED chips 252 can be mounted to a carrier 260 similar to the carriers described above, and in the embodiment shown the LED chips 252 and the carrier 260 can be mounted within the optical cavity 254. In other embodiments an optical cavity can be mounted to the carrier around the LED chips. The carrier 260 can have a reflective layer 262 on its exposed surface between the LED chips 252 as described above, and the optical cavity 254 can have reflective surfaces 264 to redirect light out the top opening of the optical cavity 254.

As second phosphor 266 is arranged over the opening of the optical cavity 254, and in the embodiment shown is in a planar shape. It is understood, however, that the second phosphor can take many different shapes, including but not limited to a dome or a globe. Similar to the embodiments above, the second phosphor 266 can comprise a phosphor that absorbs light from the LED chips 252 and emits a different color of light. In the embodiment shown, the second phosphor 266 comprises one of the yellow phosphors described above that absorbs blue light and re-emits yellow light. Like the embodiments above, blue and red light from the LED chips 252 passes through the second phosphor 266 where at least some of the blue light is absorbed by the yellow phosphor and re-emitted as yellow light. The lamp 250 can emit a white light combination of blue, red and yellow light.

The separation between the LED chips 252 and the second phosphor 266 greatly reduces the change that yellow light from the second phosphor 266 would pass into the red first phosphor 258. Like the embodiments above, this reduces the likelihood that yellow light would be absorbed by the red first phosphor and be re-emitted as red light.

FIG. 14 shows another embodiment of a lamp 280 according to the present disclosure having many of the same features as the lamp 250. In this embodiment, however, the second phosphor 282 comprises a green emitting phosphor that absorbs some of the blue light from the LED chips and re-emits green light. In operation the lamp 280 emits a white light combination of blue and red light from the LED chips and green light from the second phosphor, with the separation between the first phosphor resulting in minimal re-absorption of green light by the first phosphor.

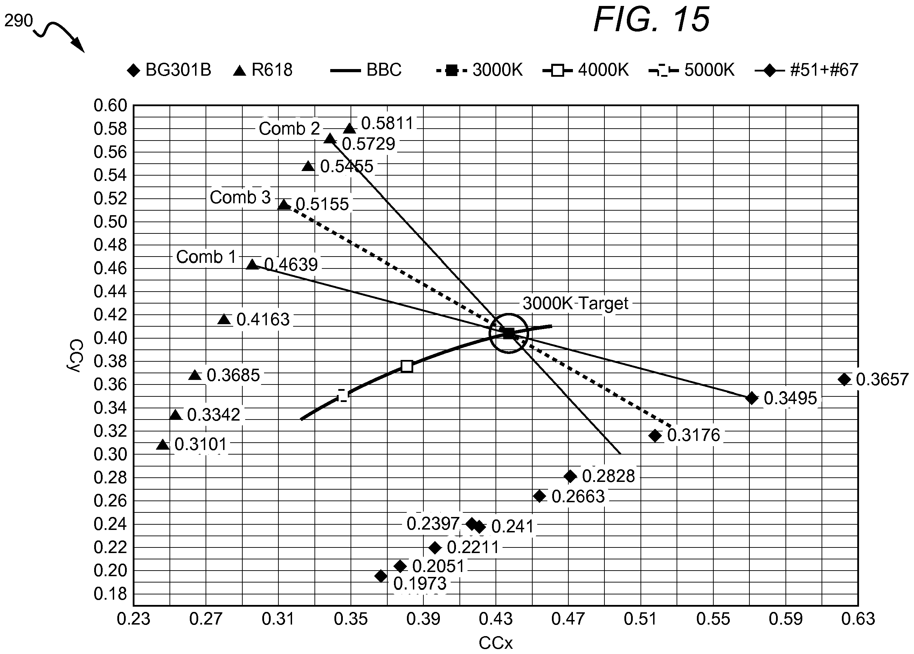

Different embodiments can combine different lighting concentrations of lighting components to achieve the desired target color and temperature. FIG. 15 is a CIE diagram 290 showing different combinations of green and red lighting components that combine on the black body curve at approximately 3000k. Combination 1 (Comb 1) has lowest green component in its emission spectrum and as a result the spectrum needs a larger red portion to achieve the desired color and temperature. Combination 2 (Comb 2) has the largest green component and as a result the lowest red component, while combination 3 (Comb 3) has a mid-point red and green component.

FIG. 16 shows another embodiment of a lamp 300 according to the present disclosure having blue LED chips 302 mounted to a carrier 304, with the LED chips 302 arranged within an optical cavity 306 having reflective surfaces 308. The first and second phosphor 310 and 312 are provided in a planar shape of the opening of the optical cavity 306, but are arranged adjacent to one another, with the first red phosphor 310 covering approximately half of the opening and the second green (or yellow) phosphor 312 covering the remainder of the optical cavity opening. Blue light from the LED chips 302 passes through the phosphors 310 and 312 where a portion of it is converted to red and green light, respectively. The lamp 300 emits a white light combination of blue, red and green light. It is understood that the phosphors can be arranged in many different region arrangements, and can also be provided in layers over one another.

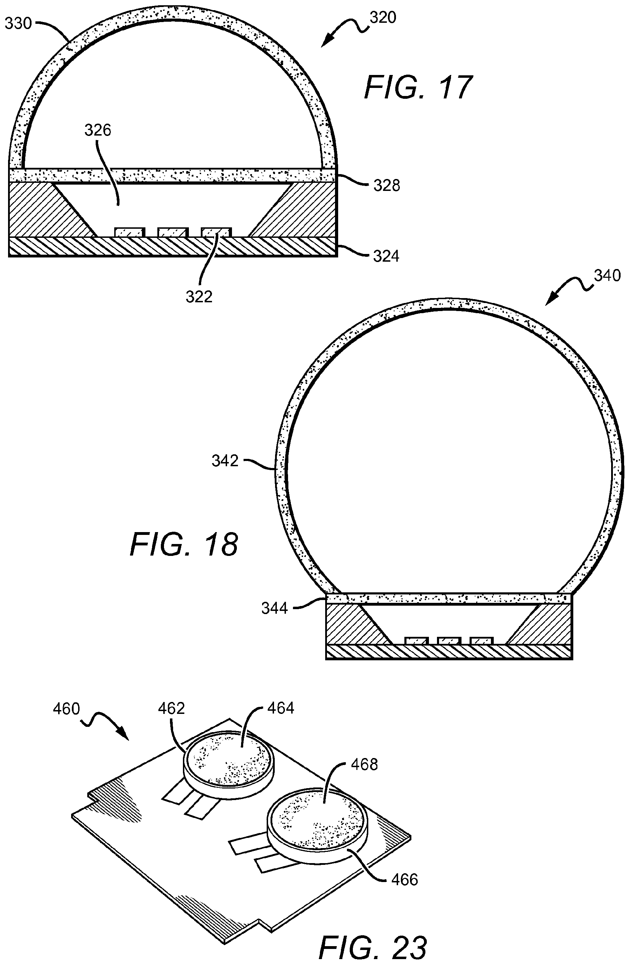

FIG. 17 shows another embodiment of a lamp 320 according to the present invention having blue LED chips 322 mounted to a carrier 324 with the LED chips 322 arranged within an optical cavity 326. A planar red first phosphor 328 is arranged over the opening of the optical cavity 326, and a second green (or yellow) phosphor 330 is arranged in dome over the first phosphor. LED light passes through the first and second phosphors with at least some being converted so that the lamp 320 emits a white light combination of blue, red and green light.

FIG. 18 shows another embodiment of a lamp 340 according to the present invention that is arranged similar to the lamp 320 shown in FIG. 17. In this embodiment, however, the second green phosphor 342 is arranged in a globe over the first phosphor 344, with this globe shape promoting re-emission of the second phosphor light in a more omnidirectional pattern. In particular, it can promote downward emission of light from the second phosphor 342.

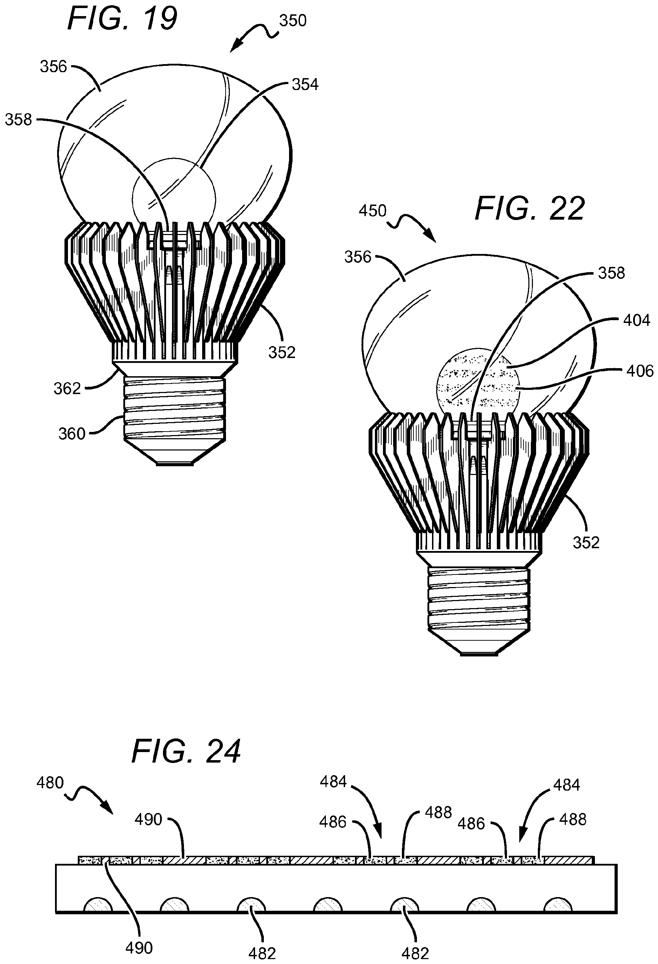

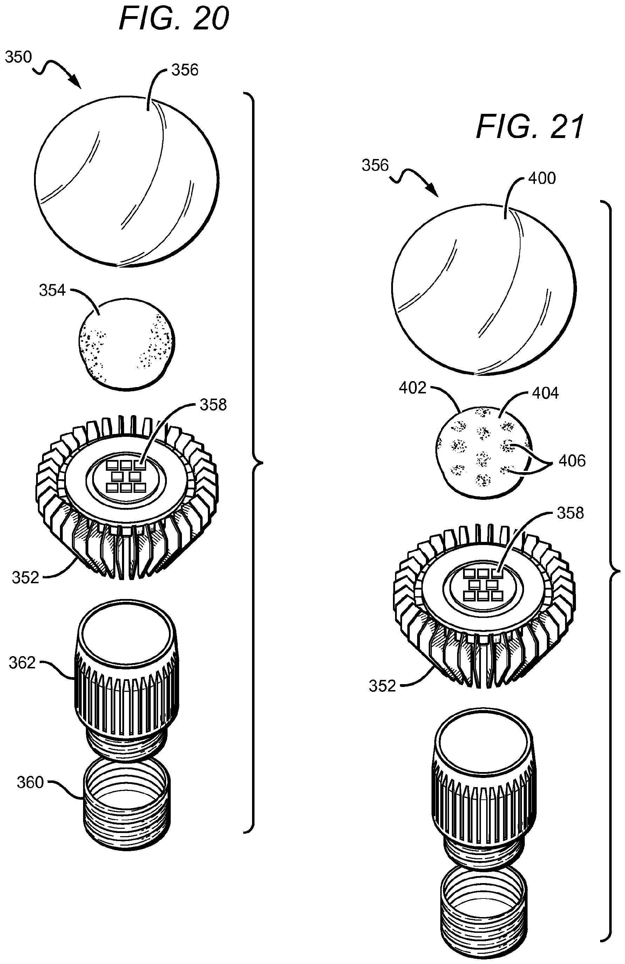

FIGs. 19 and 20 show another embodiment of a lamp 350 according to the present disclosure similar to those shown and described in U.S. Provisional Patent Application Serial No. 61/339,515, filed on March 3, 2010, and titled "Lamp With Remote Phosphor and Diffuser Configuration." and U.S. Patent Application Serial No. 12/901,405, filed on October 8, 2010, and titled "Non-uniform Diffuser to Scatter Light Into Uniform Emission Pattern," The lamp comprises a submount or heat sink 352, with a dome shaped phosphor carrier 354 and dome shaped diffuser 356. It also comprises LEDs 358 that in this embodiment are mounted on a planar surface of the heat sink 352 with the phosphor carrier and diffuser over the LED chips 358. The LED chips 358 and phosphor carrier 354 can comprise any of the arrangements and characteristics described above, such as some embodiments having a first phosphor on the LED chips 358 and second phosphor in the phosphor carrier 354, while others have the first and second phosphors as part of the phosphor carrier 354. The lamp 350 can comprise a mounting mechanism of the type to fit in conventional electrical receptacles. In the embodiment shown, the lamp 350 includes a screw-threaded portion 360 for mounting to a standard Edison socket. Like the embodiments above, the lamp 350 can include standard plug and the electrical receptacle can be a standard outlet, or can comprise a GU24 base unit, or it can be a clip and the electrical receptacle can be a receptacle which receives and retains the clip (e.g., as used in many fluorescent lights).

The lamps according to the present invention can comprise a power supply or power conversion unit that can comprise a driver to allow the bulb to run from an AC line voltage/current and to provide light source dimming capabilities. In some embodiments, the power supply can comprise an offline constant-current LED driver using a non-isolated quasi-resonant flyback topology. The LED driver can fit within the lamp 350, such as in body portion 362, and in some embodiments can comprise a less than 25 cubic centimeter volume, while in other embodiments it can comprise an approximately 20 cubic centimeter volume. In some embodiments the power supply can be non-dimmable but is low cost. It is understood that the power supply used can have different topology or geometry and can be dimmable as well.

The lamp embodiments described herein can be arranged to meet Department of Energy (DOE) Energy Star defined omnidirectional distribution criteria. One requirement of this standard met by the lamp described herein is that the emission uniformity must be within 20% of mean value from 0 to 135° viewing and; > 5% of total flux from the lamp must be emitted in the 135-180° emission zone, with the measurements taken at 0, 45, 90° azimuthal angles. The different lamp embodiments described herein can also comprise A-type retrofit LED bulbs that meet the DOE Energy Star standards. The present invention provides lamps that are efficient, reliable and cost effective. In some embodiments, the entire lamp can comprise five components that can be quickly and easily assembled.

As discussed above and shown in FIG. 16, different regions of a phosphor carrier can have different types of phosphors. In some embodiments, these different regions can provide for phosphor carriers that appear patterned. FIGs. 21 and 22 show additional lamp embodiments 400, 450 that are similar to the lamp 350 shown in FIGs. 19 and 20. The lamps also comprise a submount or heat sink 352, dome shaped diffuser 356, LEDs 358 that can be mounted on a planar surface of the heat sink 352 with the diffuser 356 over the LED chips 358. In FIG. 21 a phosphor carrier 402 is included between the LED 358 and diffuser 356, and in FIG. 22 a phosphor carrier 452 is included between the LEDs 358 and the diffuser 356. The LED chips 358 and phosphor carriers 402, 452 can comprise any of the arrangements and characteristics described above. It these embodiments, however, the phosphor carriers 402, 452 each comprise different first and second phosphors 404, 406, with the first and second phosphors in different regions. For phosphor carrier 402, the first phosphor 404 covers most of the phosphor carrier area, while the second phosphor is arranged as dots on others of the phosphor carrier areas. The overall phosphor carrier 404 appears to be patterned with dots. In other embodiments the first phosphor can cover all of the phosphor carrier and second phosphor can comprise dots on the first phosphor.

For phosphor carrier 452 in FIG. 22, the first phosphor 404 can cover most of the phosphor carrier while the second phosphor 406 can comprise stripes covering other portions of the phosphor carrier. In still other embodiments the first phosphor 404 can cover all of the phosphor carrier, and the second phosphor 406 can cover the first phosphor in a stripe pattern.

These are only some of the many different patterns that can be included on phosphor carriers according to the present invention. It is also understood that the phosphor carriers according to the present invention can comprise a transparent carrier material in a three-dimensional (e.g dome) or planar shape, with the phosphors described above being on the outside surface or inside surface of the transparent carrier, or on both surfaces. The portions of the pattens described above can also be on different spaced apart phosphor carriers. For example, the dot arrangement of one phosphor can be on a first phosphor carrier that is spaced apart from the a second phosphor carrier with the other phosphor. The different phosphor carriers can be planar or three-dimensional.

FIG. 23 shows still another embodiment of a lamp 460 according to the present disclosure comprising a first emitter package 462 with a green phosphor 464, and a second emitter package 466 with a red phosphor 468. The emission from the packages 464, 466 is directional such that nearly all of the light from the each of the emitters does not fall on the other. As a result, the light from the green phosphor 414 will not pass into the red phosphor 468 where it risks being re-absorbed. This type of lateral separation provides and even greater reduction in the amount of light that can be re-absorbed, and thereby further reduces the negative impact that re-absorption can have on a lamps CRI.

FIG. 24 shows still another lamp or display 480 according to the present disclosure having a plurality of blue LED chips 482 with spaced from a layer comprising a plurality of transmissive lamp/luminaire pixels 484. Each pixel 484 can comprise red or green quantum dots or phosphors 486, 488 that absorb blue light from the LED chips 482 and emit red and green light, respectively. A diffusing or reflective material 490 can be arranged between the red and green phosphors 486, 488 and between adjacent pixels 484 to reduce interaction or cross-talk between adjacent converter materials. Separation is provided between the red and green phosphors and efficiency improvements can be achieved by including the diffuser or reflective material 490 between the phosphors. The diffuser or reflective material can be optically opaque or translusive and helps prevent light from phosphor being reabsorbed by another.

Some of the above embodiments are described with reference to a first conformal phosphor coating with a second phosphor spaced apart from the first, such as in the shape of a dome. It is understood, that the second phosphor can be provided in many different shapes beyond a dome, and more than one phosphor can be provided in a dome. For example, the first phosphor can be provided in a dome over one or more of the LEDs, with the second phosphor provided as a dome over the first dome. It is also understood that more than two phosphors can be utilized in different conformal coatings or separated in different dome arrangements. It is also understood that one or more of the phosphors can comprise a disk that can be used in combination with other phosphor disks, or can be used in combination with phosphor globes or domes. The separation can also comprise in plane pixilation, such as in plane separation of LEDs coated with different materials such as yellow and red phosphors. There can also be many variations to the in plane package separation as described above.

Although the present invention has been described in detail with reference to certain preferred configurations thereof, other versions are possible.

## Claims

1. A solid state lamp (320; 340), comprising:
light emitting diodes (LEDs) (322) on a carrier 324);
a planar first conversion material (328; 344), wherein light from said LEDs passes through said first conversion material, wherein at least some of the light from the LEDs is wavelength converted and re-emitted; and
a second conversion material (330; 342) arranged in a dome or globe over said first conversion material, with light from said LEDs passing through said second conversion material, wherein said second conversion material wavelength converts and re-emits at least some of said LED light;
**characterized in that** said first conversion material comprises an excitation spectrum (32) that overlaps with the re-emission spectrum (34, 42) of said second conversion material.

2. The lamp of claim 1, wherein said first and second conversion materials (328, 330; 344, 342) comprise phosphors.

3. The lamp of claim 1 or 2, wherein said second conversion material (342) is arranged in a globe over said first conversion material (344).

4. The lamp of claim 1 or 2, wherein said second conversion material (330) is arranged in a dome over said first conversion material (48; 112; 148; 168; 328).

5. The lamp of any preceding claim, wherein said first conversion material (328; 344) absorbs light from said LEDs (322) and re-emits red light.

6. The lamp of any preceding claim, wherein said second conversion material (330; 342) absorbs light from said LEDs (322) and re-emits yellow or green light.

7. The lamp of any preceding claim, emitting a white light combination or light from at least two of the sources comprising said LEDs (322), said first conversion material (328; 344) and said second conversion material (330; 342).

8. The lamp of any preceding claim, emitting a white light combination or light from said LEDs (22), said first conversion material (328; 344) and said second conversion material (330; 342).

9. The lamp of any preceding claim, further comprising a diffuser (356) over said second conversion material (354).

10. The lamp of any preceding claim, wherein said diffuser (356) is dome or globe shaped.

11. The lamp of any preceding claim, wherein said LEDs (322) are in an optical cavity (326).

12. The lamp of claim 11, wherein said first conversion material (328) is over the opening of the optical cavity (326) .

## Patentansprüche

1. Feststofflampe (320; 340), umfassend:
lichtemittierende Dioden (LEDs) (322) auf einem Träger (324);
ein planares erstens Konversionsmaterial (328; 344), wobei Licht von den LEDs durch das erste Konversionsmaterial tritt, wobei wenigstens ein Teil des Lichts von den LEDs wellenlängenkonvertiert und reemittiert wird; und
ein zweites Konversionsmaterial (330; 342), angeordnet in einer Kuppel oder einer Kugel über dem ersten Konversionsmaterial, wobei Licht von den LEDs durch das zweite Konversionsmaterial tritt, wobei das zweite Konversionsmaterial wenigstens einen Teil des LED-Lichts wellenlängenkonvertiert und reemittiert;
**dadurch gekennzeichnet, dass**
das erste Konversionsmaterial ein Anregungsspektrum (32) umfasst, das mit dem reemittierten Spektrum (34, 43) des zweiten Konversionsmaterials überlappt.

2. Lampe nach Anspruch 1, wobei die ersten und zweiten Konversionsmaterialien (328, 330; 344, 342) Phosphor umfassen.

3. Lampe nach Anspruch 1 oder 2, wobei das zweite Konversionsmaterial (342) in einer Kugel über dem ersten Konversionsmaterial (344) angeordnet ist.

4. Lampe nach Anspruch 1 oder 2, wobei das zweite Konversionsmaterial (330) in einer Kuppel über dem ersten Konversionsmaterial (48; 112; 148; 168; 328) angeordnet ist.

5. Lampe nach einem vorstehenden Anspruch, wobei das erste Konversionsmaterial (328; 344) Licht der LEDs (322) absorbiert und rotes Licht reemittiert.

6. Lampe nach einem vorstehenden Anspruch, wobei das zweite Konversionsmaterial (330; 342) Licht der LEDs (322) absorbiert und gelbes oder grünes Licht reemittiert.

7. Lampe nach einem vorstehenden Anspruch, die eine Weißlichtkombination oder Licht von wenigstens zwei der die LEDs (322), das erste Konversionsmaterial (328; 344) und das zweite Konversionsmaterial (330; 342) umfassenden Quellen emittiert.

8. Lampe nach einem vorstehenden Anspruch, die eine Weißlichtkombination oder Licht von den LEDs (22), dem ersten Konversionsmaterial (328; 344) und dem zweiten Konversionsmaterials (330; 342) emittiert.

9. Lampe nach einem vorstehenden Anspruch, ferner umfassend einen Umlenker (356) über dem zweiten Konversionsmaterial (354).

10. Lampe nach einem vorstehenden Anspruch, wobei der Umlenker (356) kuppel- oder kugelförmig ist.

11. Lampe nach einem vorstehenden Anspruch, wobei die LEDs (322) sich in einer optischen Kavität (326) befinden.

12. Lampe nach Anspruch 11, wobei das erste Konversionsmaterial (328) sich über der Öffnung der optischen Kavität (326) befindet.

## Revendications

1. Lampe à semi-conducteurs (320 ; 340), comprenant :
des diodes électroluminescentes (LED) (322) sur un support (324) ;
un premier matériau de conversion plat (328 ; 344), dans laquelle de la lumière provenant desdites LED passe à travers ledit premier matériau de conversion, dans laquelle au moins une partie de la lumière provenant des LED est convertie en longueur d'onde et réémise ; et
un second matériau de conversion (330; 342) agencé en un dôme ou globe sur ledit premier matériau de conversion, de la lumière provenant desdites LED passant à travers ledit second matériau de conversion, dans laquelle ledit second matériau de conversion convertit en longueur d'onde et réémet au moins une partie de ladite lumière LED ;
**caractérisée en ce que**
ledit premier matériau de conversion comprend un spectre d'excitation (32) qui se chevauche avec le spectre de réémission (34, 42) dudit second matériau de conversion.

2. Lampe selon la revendication 1, dans laquelle lesdits premier et second matériaux de conversion (328, 330 ; 344, 342) comprennent des luminophores.

3. Lampe selon la revendication 1 ou 2, dans laquelle ledit second matériau de conversion (342) est agencé en un globe sur ledit premier matériau de conversion (344).

4. Lampe selon la revendication 1 ou 2, dans laquelle ledit second matériau de conversion (330) est agencé en un dôme au-dessus dudit premier matériau de conversion (48; 112; 148; 168; 328).

5. Lampe selon l'une quelconque des revendications précédentes, dans laquelle ledit premier matériau de conversion (328 ; 344) absorbe de la lumière provenant desdites LED (322) et réémet de la lumière rouge.

6. Lampe selon l'une quelconque des revendications précédentes, dans laquelle ledit second matériau de conversion (330; 342) absorbe de la lumière provenant desdites LED (322) et réémet de la lumière jaune ou verte.

7. Lampe selon l'une quelconque des revendications précédentes, émettant une combinaison de lumière blanche ou de la lumière provenant d'au moins deux des sources comprenant lesdites LED (322), ledit premier matériau de conversion (328 ; 344) et ledit second matériau de conversion (330 ; 342).

8. Lampe selon l'une quelconque des revendications précédentes, émettant une combinaison de lumière blanche ou de la lumière provenant desdites LED (22), dudit premier matériau de conversion (328 ; 344) et dudit second matériau de conversion (330; 342).

9. Lampe selon l'une quelconque des revendications précédentes, comprenant en outre un diffuseur (356) au-dessus dudit second matériau de conversion (354).

10. Lampe selon l'une quelconque des revendications précédentes, dans laquelle ledit diffuseur (356) est en forme de dôme ou de globe.

11. Lampe selon l'une quelconque des revendications précédentes, dans laquelle lesdites LED (322) sont dans une cavité optique (326).

12. Lampe selon la revendication 11, dans laquelle ledit premier matériau de conversion (328) est au-dessus de l'ouverture de la cavité optique (326).
